Europäisches Patentamt

European Patent Office

Office européen des brevets

(11) Veröffentlichungsnummer: **0 301 255**
**A1**

## (12) EUROPÄISCHE PATENTANMELDUNG

(21) Anmeldenummer: **88110310.5**

(22) Anmeldetag: **28.06.88**

(51) Int. Cl.⁴: **H05K 13/08**

(30) Priorität: **30.07.87 DE 3725316**

(43) Veröffentlichungstag der Anmeldung:
**01.02.89 Patentblatt 89/05**

(84) Benannte Vertragsstaaten:
**CH DE FR GB IT LI**

(71) Anmelder: **Siemens Aktiengesellschaft Berlin und München**
**Wittelsbacherplatz 2**
**D-8000 München 2(DE)**

(72) Erfinder: **Doemens, Günter, Dr.-Ing.**
**Eichenfeldstrasse 4**
**D-8150 Holzkirchen(DE)**

(54) **3D-Lageerkennung von Bauelementeanschlüssen für die automatische Bestückung.**

(57) Für einen vollautomatisierten Einsatzvorgang wird die Lage der Bauelementeanschlußenden in allen drei Raumkoordinaten erfaßt bzw. überprüft und dann mit diesen Daten der Montagevorgang korrigiert. Zur Lageerkennung dient eine Kombination des Stereoskopieprinzips, der telezentrischen Abbildung und einer Durchlichtbeleuchtung. Aus den daraus erzeugten Binärbildern wird die räumliche Lage der Bauelementeanschlüsse automatisch durch eine Auswerteeinheit bestimmt.
Anwendungsgebiet: Flachbaugruppen, Bestückautomaten.

**FIG 1**

EP 0 301 255 A1

## 3D-Lageerkennung von Bauelementeanschlüssen für die automatische Bestückung.

Die Erfindung betrifft eine Vorrichtung zur Erkennung von dreidimensionalen Objekten, vorzugsweise zur automatischen Bestückung von elektrischen und elektronischen Sonderbauelementen und SMD's (oberflächenmontierten Bauelementen) mit kleinem Anschlußraster.

Ein Hauptziel bei flexiblen Flachbaugruppenmontagen liegt in der vollautomatischen Bestückung aller Bauelemente. Bei DIL-Bauformen (Dual-In-Line) in konventionellem Raster, bei üblichen axialen Bauelementen sowie bei Standard-SMD-Bauelementen (surface mounted devices) ist dies durch hochentwickelte Einsetzautomaten heute gelöst. Erhebliche Probleme treten jedoch bei der automatischen Bestückung von Sonderbauelementen und hochpoligen SMD's mit kleinem Anschlußraster auf. Hier ist die Relativposition der Bauelementeanschlüsse zum Greifpunkt des Bestückwerkzeuges aufgrund von Herstelltoleranzen bzw. Verbiegungen so starken Streuungen unterworfen, daß die Montage nicht unabhängig von den Eigenschaften des einzelnen Bauelementes ablaufen kann.

Für die genaue Lageerkennung von Objektpunkten im Raum sind grundsätzlich zwei Verfahren denkbar:

     a) Lasertriangulation

     b) Stereoskopie.

Die Triangulationsverfahren beinhalten, daß schon bei der Bildaufnahme die dritte Dimension erfaßt wird. Dabei wird ein Punkt P $(x, y, z)$ des Objektes unter dem bekannten Winkel $\alpha$ betrachtet. Aus dem Winkel $\phi$ , sowie aus den in Betrachtungsrichtung beobachteten Koordinaten $(x', y')$ des Lichtpunktes, läßt sich die Raumkoordinate P $(x, y, z)$ des Objektes nach trigonometrischen Berechnungen bestimmen und so die gesamte Oberfläche des Objektes dreidimensional erfassen.

Mit Stereoskopie bezeichnet man die Gesamtheit der Verfahren und Techniken zur raumgetreuen Bildwiedergabe und Erzielung eines Raumeindruckes nach dem Prinzip des stereoskopischen Sehens, das heißt, aus zwei oder mehreren Blickrichtungen die räumliche Lage eines Objektes zu erkennen. Beide Verfahren sind jedoch unter der Voraussetzung, daß sie in bekanntem Sinn eingesetzt sind, für den vorliegenden Anwendungsfall sowohl zu kostenintensiv als auch im Hinblick auf die kurzen Montagezyklen in den Reaktionszeiten zu langsam. Universelle 3D-Erkennungssysteme für die Flachbaugruppenmontage sind deshalb zur Zeit noch nicht im Einsatz.

Der Erfindung liegt die Aufgabe zugrunde, mit einfachen Mitteln eine Vorrichtung zum vollautomatisierten Einsatz zu konzipieren, die die Lage der Bauelementeanschlußenden in allen drei Raumkoordinaten erfaßt bzw. überprüft und dann mit diesen Daten den Montagevorgang korrigiert.

Diese Aufgabe wird gemäß dem Kennzeichen des Anspruchs 1 gelöst. Vorteilhafte Ausführungsformen und Weiterbildungen der Erfindung sind in den Unteransprüchen enthalten.

Das Problem der universellen, schnellen und kostengünstigen 3D-Lageerkennung von Bauelementeanschlüssen wird durch die Kombination des Stereoskopieprinzips, der telezentrischen Abbildung und einer Durchlichtbeleuchtung gelöst. Die übliche Stereoskopie ermittelt aus Bildern, von unterschiedlichen Richtungen aufgenommen, die räumliche Lage von Objektpunkten. Telezentrische Abbildung heißt, das Objekt darf sich in unterschiedlicher Entfernung vom Empfänger befinden, ohne daß der Abbildungsmaßstab dadurch verändert wird.

Dabei arbeitet man normalerweise im Auflicht und unter verschiedenen Strahlrichtungen. Die dadurch notwendigen umfangreichen trigonometrischen Berechnungen, die für jeden Punkt durchgeführt werden müssen, machen das Verfahren sehr zeitintensiv. Bei der Lageerkennung von Bauelementeanschlüssen kann man jedoch im Durchlicht arbeiten und damit die notwendigen Abbildungen mit einem telezentrischen Strahlengang durchführen. Durch diese optischen Maßnahmen reduziert sich die Verarbeitung auf Binärbilder, zum anderen wird durch die "unendliche" Tiefenschärfe der telezentrischen Abbildung die Berechnung der Raumkoordinaten auf wenige lineare Operationen zurückgeführt.

Die automatische Korrektur ist Voraussetzung für eine absolut fehlerfreie Montage und damit für die Herstellung einer qualifiziert hochwertigen Flachbaugruppe.

Die Erfindung wird anhand der Figuren erläutert. Es zeigen:

Figur 1 schematisch die Realisierung für die Bestimmung von Sonderbauelementen (zum Beispiel Relais),

Figur 2 das Binärbild aus Richtung B,

Figur 3 das Binärbild aus Richtung A,

Figur 4 die Bestückung von SMD's (oberflächenmontierten Bauelementen) mit Anschlußbeinchen,

Figur 5 das Diodenzeilensignal aus Richtung B und

Figur 6 das Diodenzeilensignal aus Richtung A.

Ein Beleuchtungssystem besteht zum Beispiel aus einer Lichtquelle 1 und einem Kondensor 2. Ein Empfängersystem setzt sich zum Beispiel aus einer Bildaufnahmekamera 3 und einer abbildenden Optik 4 zusammen. Abbildungs- und/oder Beleuchtungssystem sind so ausgelegt, daß aus dem Objektbereich nur achsenparallele Strahlen 5 (telezentrischer Strahlengang) auf die Kamera 3 auftreffen. Die achsenparallelen Strahlen können entweder mit einer Blende 6 in der abbildenden Optik oder durch entsprechende Dimensionierung der Beleuchtungsoptik erzielt werden. Zwischen dem Abbildungssystem und dem Beleuchtungssystem ist ein Objekt 7 dargestellt.

Zur Realisierung des Stereoskopieprinzips wird mit dieser Anordnung das Objekt aus zwei verschiedenen Richtungen A und B erfaßt. Das kann entweder durch eine zusätzliche zweite Anordnung oder durch differenziertes Drehen des Objekts erreicht werden. Bei Vorhandensein von zwei Kameras kann die Betrachtung gleichzeitig erfolgen, während mit einer Kamera dieses nacheinander erfolgt.

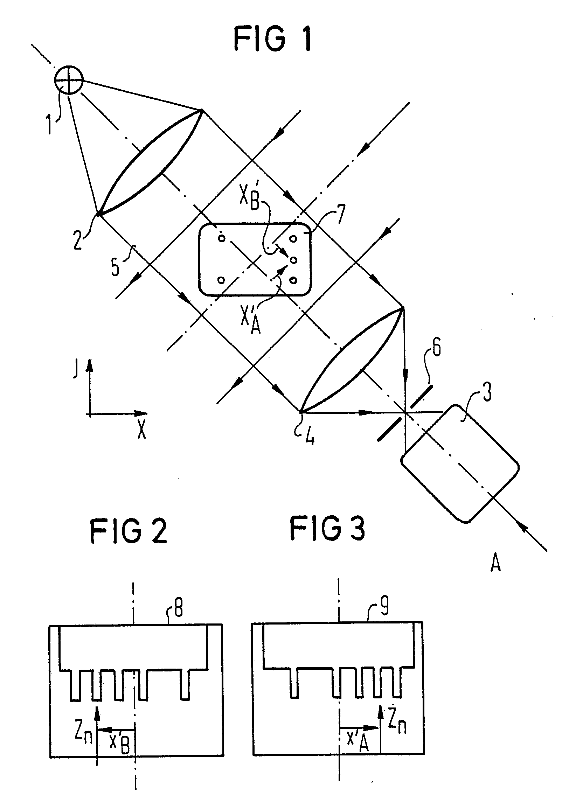

Die Figuren 2 und 3 zeigen mit 8 und 9 die aus verschiedenen Richtungen aufgenommenen Bilder des Objektes, die dann binärisiert einer nicht dargestellten Auswerteinheit zugeführt werden. Die räumliche Lage (x, y, z) der Anschlüsse ergibt sich daraus nach einfachen geometrischen Beziehungen aus den bekannten Winkel zwischen den zwei Betrachtungsrichtungen für den Sonderfall 90° aus den Formeln:

$$x_n = C + B (x_A - x_B)$$
$$y_n = C + B (x_A + x_B)$$

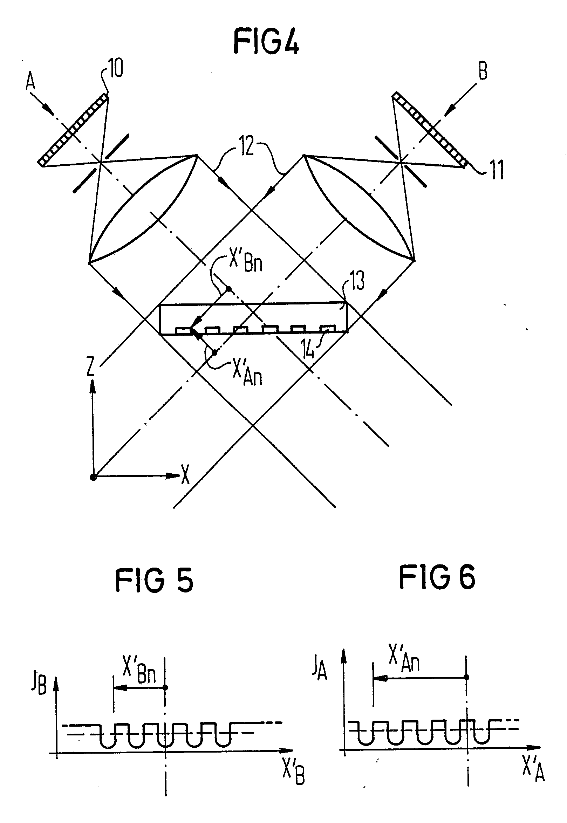

Die Figur 4 zeigt schematisch die Realisierung für die Bestückung von hochpoligen SMD's, während in der Figur 1 Sonderbauelemente zugrundegelegt sind.

In der Figur 4 ist die Realisierung von zwei telezentrischen Strahlengängen in Verbindung mit einem eindimensionalen Bildwandler 10, 11 (Diodenzeile) zugrundegelegt. Mit 12 ist der Bereich der telezentrischen Strahlen und mit 13 ein Oberflächen montiertes Bauelement mit Anschlußbeinchen 14 bezeichnet.

Die Diagramme 5 und 6 zeigen die Videosignale der beiden Diodenzeilen 10, 11, aus denen nach den Formeln

$$x_n = C + B (x_{An}' - x_{Bn}')$$
$$z_n = C + B (x_{An}' + x_{Bn}')$$

unzulässige Verbiegungen und Teilungsfehler abgeleitet werden können.

C und B sind Konstante aus der geometrischen Berechnung für den Sonderfall 90°.

**Ansprüche**

1. Vorrichtung zur Erkennung von dreidimensionalen Objekten, vorzugsweise zur automatischen Bestückung von elektrischen und elektronischen Sonderbauelementen und Oberflächen montierten Bauelementen mit kleinem Anschlußraster, **dadurch gekennzeichnet,** daß zur Lageerkennung eine Kombination des Stereoskopieprinzips, der telezentrischen Abbildung und einer Durchlichtbeleuchtung vorgesehen sind und daß aus den daraus erzeugten Binärbildern die räumliche Lage der Bauelemente automatisch durch eine Auswerteinheit bestimmt wird.

2. Vorrichtung nach Anspruch 1 für Sonderbauelemente, deren Beinchen in Leiterplattenbohrungen gesteckt werden, **dadurch gekennzeichnet,** daß die beiden Betrachtungsrichtungen (A, B) in einer Ebene zur Montageebene (Leiterplatte) angeordnet sind, und daß die Bilder (8, 9) mit einem eindimensionalen bzw. zweidimensionalen Bildwandler erfaßt werden (Figur 1).

3. Vorrichtung nach Anspruch 1 für die Erkennung der Lage von Anschlußbeinchen bei oberflächenmontierten Bauelementen, **dadurch gekennzeichnet,** daß die beiden Betrachtungsrichtungen (A, B) in einer Ebene verlaufen, die schräg bzw. senkrecht zur Montageebene (Leiterplatte) angeordnet ist, und daß die Bilder (Figur 5, 6) sowohl mit einem eindimensionalen als auch mit einem zweidimensionalen Bildwandler erfaßt werden (Figur 4).

FIG 1

FIG 2    FIG 3

# FIG4

# FIG 5

# FIG 6

Europäisches
Patentamt

**EUROPÄISCHER RECHERCHENBERICHT**

Nummer der Anmeldung

EP 88 11 0310

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-4 598 456 (McCONNELL) <br> * Insgesamt * <br> --- | 1,2 | H 05 K 13/08 |
| A | IBM TECHNICAL DISCLOSURE BULLETIN, Band 26, Nr. 7B, Dezember 1983, New York, US, Seiten 3664-3666; V. DI LORENZO et al.: "Component position recognition method and device for an assembly robot" <br> * Insgesamt * <br> --- | 1,2 | |
| A | EP-A-0 062 335 (HITACHI) <br> * Seite 10, Zeile 19 - Seite 13, Zeile 5; Figuren 6,7 * <br> ----- | 1,3 | |
| | | | **RECHERCHIERTE SACHGEBIETE (Int. Cl.4)** <br><br> H 05 K 13/00 |

Der vorliegende Recherchenbericht wurde für alle Patentansprüche erstellt

| Recherchenort | Abschlußdatum der Recherche | Prüfer |
|---|---|---|
| DEN HAAG | 25-10-1988 | RIEUTORT A.S. |